Europäisches Patentamt

European Patent Office

Office européen des brevets

(11) Publication number: **0 296 718**
**A2**

## EUROPEAN PATENT APPLICATION

(21) Application number: 88304765.6

(22) Date of filing: 26.05.88

(51) Int. Cl.⁴ **H01L 21/82** , **H01L 21/28** , **H01L 29/40**

(30) Priority: 26.06.87 US 67509

(43) Date of publication of application:
28.12.88 Bulletin 88/52

(84) Designated Contracting States:
DE FR GB

(71) Applicant: **Hewlett-Packard Company**
**3000 Hanover Street**
**Palo Alto California 94304(US)**

(72) Inventor: **Chiu, Kuang-Yi**
**12882 Viscaino**
**Los Altos Hills California 94022(US)**

(74) Representative: **Colgan, Stephen James et al**
**CARPMAELS & RANSFORD 43 Bloomsbury Square**
**London WC1A 2RA.(GB)**

(54) **A coplanar and self-aligned contact structure.**

(57) An integrated circuit chip and a method of forming said chip. A substrate having a planar surface, has, formed thereon at least two field oxide regions separated from each other, each having separate diffusion regions, all coplanar with the planar surface. Over that are at least three separate coplanar polysilicon deposits, comprising a gate deposit bridging over and between the two separate diffusion regions, and second and third deposits, each over one of two field oxide regions. A highly conductive path is formed over each polysilicon deposit, one over the gate and confined thereto, and two others, each extending from a top of a polysilicon deposit down to and in good electrical contact with its adjacent diffusion region. A passivation layer overlies all of the integrated circuit portions so far described, covering all three of the polysilicon deposits, all of which are coplanar with each other. The passivation layer has an opening leading to each of the second and third coplanar polysilicon deposits. Metal contacts extend down into each said opening and to the polysilicon deport thereof.

FIG II

# A COPLANAR AND SELF-ALIGNED CONTACT STRUCTURE

## Field of Invention

This invention relates to a coplanar and self-aligned contact structure for submicron semiconductor devices.

## Background of the Invention

It is a well-known fact that the trend of device scaling has made it more difficult to provide contacts to interconnect devices that can fulfill the stringent requirements of submicron CMOS/VLSI. For example, such difficulties arise as contact resistivity, and there are spiking problems due to shallow source/drain junctions. There are contact etch stop problems, due to the tight requirements in geometry controls and the planarization requirement for metal step coverage concerns. To develop a useful contact technology for submicron VLSI circuit fabrication, all of the aforementioned issues need to be addressed simultaneously. Many process innovations have been reported, such as SALICIDE, reflow, planarization etc., to alleviate or to eliminate some of the difficulties regarding contact and/or interconnect problems for submicron CMOS/VLSI. So far, there has been no clear-cut solution which can solve all of those difficulties simultaneously.

## Summary of the Invention

The present invention presents a new contact approach by placing a polysilicon pad, during standard polysilicon gate patterning, on field oxide regions where diffusion contacts are to be opened later on. Interconnections in between the polysilicon pads to source/drain diffusion regions or in between the diffusion regions themselves are preferably achieved through a layer of highly conductive material without the need for open contacts inside a diffusion area. Materials such as a silicide layer or a TiN or TiW layer, or other conductive materials can be used to implement this contact structure.

This contact structure provides the capability to alleviate and/or to eliminate many difficulties of conventional contact technology, which needs to open contacts in both source/drain diffusion and polysilicon/field oxide regions. Since no contact is to be opened within the source/drain diffusion regions, junction spiking due to interconnect metal and contact degradation due to contact hole etching or due to contact plug process (selective tungsten plug) can be avoided by this approach. All contacts are opened on polysilicon and on field oxide, so that etch stop difficulties due to prior-art planarization processes can be minimized. In addition, all the advantages provided by the HPSAC local interconnect scheme are preserved, including minimum diffusion/sidewall capacitance and buried contact capability for CMOS.

The key features of this new contact scheme are:

(1) All contacts are coplanar.

(2) All contacts are identical, both on polysilicon and on the field region.

(3) Shallow junction problems due to spiking are eliminated.

(4) Stress effects from metal layers or from contact plug materials are also eliminated.

(5) There are no severe contact etch stop requirements.

(6) There is only one registration error for all the contacts in the VLSI circuits.

(7) Oversized and/or coincident contacts became possible.

(8) There is no need for special planar isolation topology, as is required when backend processing is used.

In summary, the key feature of this invention is that of placing a polysilicon pillar on field oxide where the source/drain contacts are to be patterned later on and of using a conductive material layer to provide the necessary interconnections from (1) the diffusion areas to the polysilicon pillars (to provide the source/drain contacts), (2) from diffusion to the polysilicon gates (buried contacts), and (3) from diffusion to diffusion for local interconnection.

## Brief Description of the Drawings

Fig. 1 is a greatly enlarged, somewhat diagrammatic view in elevation and partly in section of an integrated circuit portion as made by a very popular prior art method and shown before application of the upper metal layer.

Fig. 2 is a view of the same prior-art structure after the metal layer has been applied.

Fig. 3 is a greatly enlarged, diagrammatic view of an integrated circuit portion at an early step in the process of manufacture by a method embodying the principles of the present invention.

Fig. 4 is a similar view of the same integrated circuit portion at a succeeding step in this method.

Fig. 5 is a similar view of the same integrated circuit portion at a step made thereafter in this new method.

Fig. 6 is a similar view of the same circuit chip at a later stage of this method.

Fig. 7 is a similar view of the same chip after application of the metal contacts.

Fig. 8 is a view similar to Fig. 5 of alternative step later than the stage of Fig. 5 in the production of another structure embodying the principles of the invention, where oversize contacts or external contacts are desired.

Fig. 9 is a similar view of the chip of Fig. 8 at a succeeding stage.

Fig. 10 is a view of the chip of Fig. 9 at a later stage.

Fig. 11 is a view like Fig. 7 of the chip of Figs. 8-10 showing the metal added to Fig. 10 with oversized contacts.

## Description of some Preferred Embodiments.

### Description of a prior art device

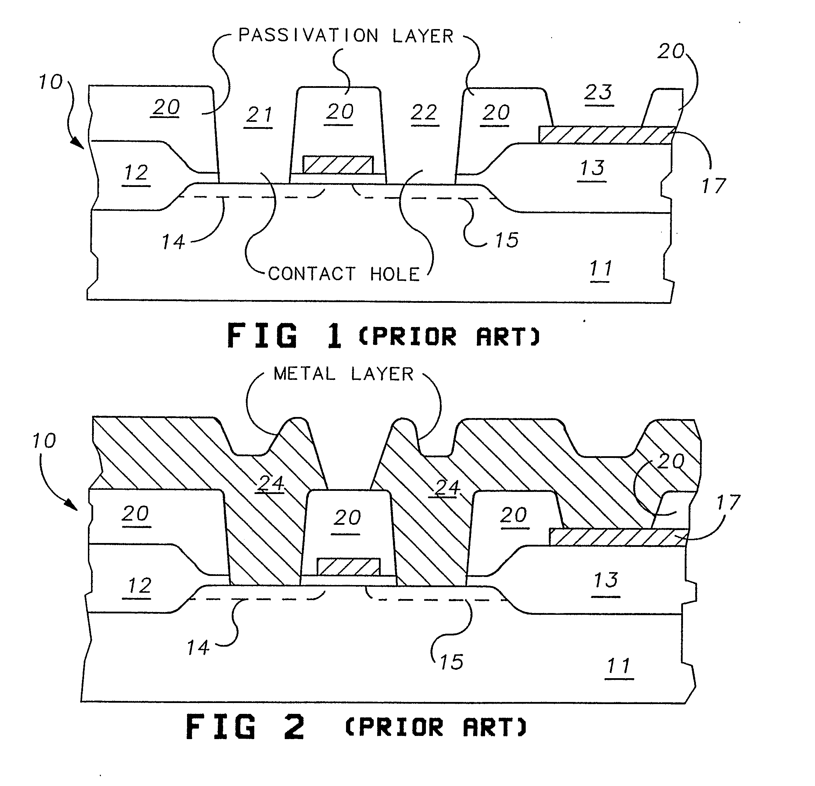

In the prior art, as shown in Figs. 1 and 2, an integrated circuit device such as a MOSFET 10 was fabricated on a semiconductor substrate 11, such as silicon, to provide a pair of field oxide layers 12 and 13 with respective diffusion portions 14 and 15 separated from each other. The layers 12 and 13 extended above the level of the substrate 11 and the diffusion portions 14 and 15.

A gate 16, for example of polysilicon, overlays parts of both of the diffusion portions 14 and 15 and the portion of the substrate 11 separating them. A polysilicon layer 17 also overlays one field oxide portion 13. Then, a passivation layer 20, such as phosphosilicate glass, was uniformly deposited over the MOSFETs, and contact holes 21, 22 and 23 were etched through the passivation layer 20 over the sources and drains 14, 15 and 17 of the MOSFET 10.

As illustrated in Fig. 2 a metal layer 24, as for example an aluminum alloy, was then deposited over the passivation layer 20 and into the contact holes 21, 22 and 23 to create contacts to the sources, drains and gate of the MOSFET 10. The metal layer 24 was patterned for correct interconnection of the various MOSFETs of the integrated circuit.

Although this prior art method was generally adequate, it became less so as such devices became progressively smaller. It was subject to lithographic misalignment and to undercutting during contact etch. In consequence, such MOSFET devices 10 required spacing between their source and drain contact holes 21 and 22 and the edges of the polysilicon gate 16 and the field oxide portion 13. This additional spacing requirement resulted in wasted areas in the integrated circuit and increased junction capacitances, and it limited the density of the integrated circuit. Furthermore, the spacing between a contact hole 21 or 22 and the edge of the active device increased the contact resistance, and consequently further degraded the performance of the device. Attempts to solve device scaling problems in circuit performance led to very shallow junctions at the source or the drain and often resulted in spiking problems, in which the metal went all the way through the junction into direct contact with the substrate 11. Various attempts were made to solve the problem, but so far no clear-cut solution has been presented.

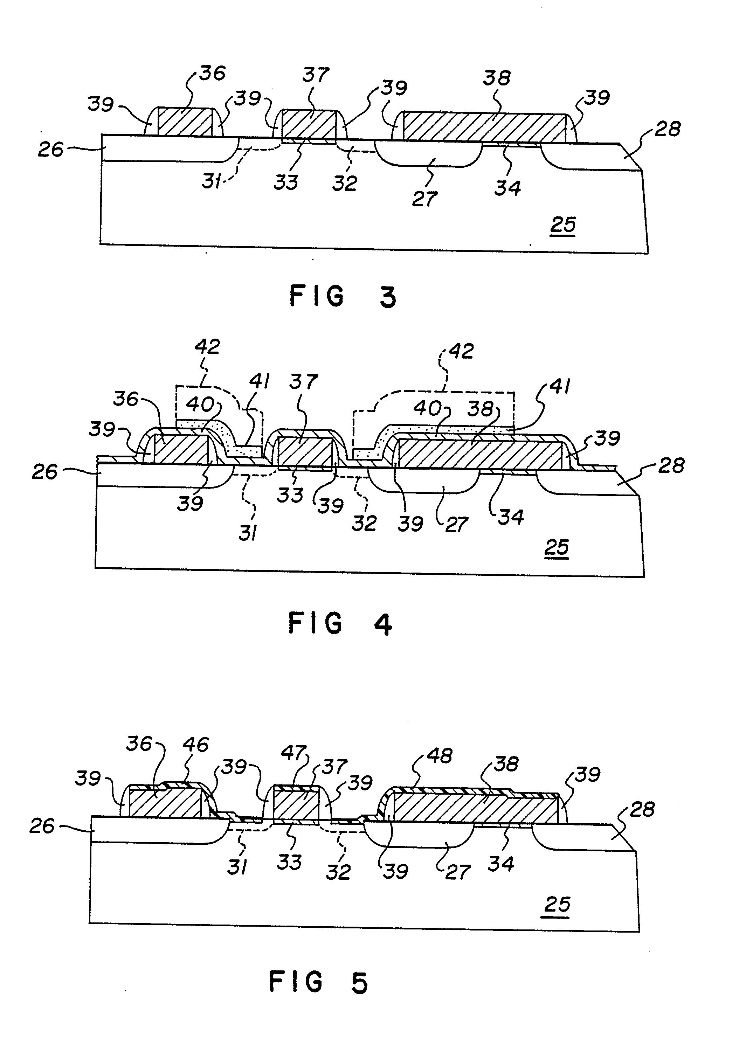

### The device of Figs. 3-7 according to the present invention

In the present invention, again there is a substrate 25, which may be of silicon, and there are field oxide layers 26, 27, and 28 which may be a type of SWAMI (Side Wall Masked Isolation process) structure, the upper surfaces of which are made to be precisely on a level with the top surface of the diffusion portions 31 and 32, all as shown in Fig. 3.

A layer of gate oxide, e.g., silicon dioxide, is thermally grown on silicon and then a layer of polysilicon is deposited. This is followed by plasma etching, to produce the structure of Fig. 3, where there are still two portions 33 and 34 of gate oxide and three areas or layers 36, 37, or 38 of polysilicon. Each of these layers 36, 37, 38 is of the same thickness and their upper surfaces are coplanar, -- an important feature of the invention. They comprise gates 37 and 38 and a pad 36. Only the central gate 37 overlies portions of both diffusion layers 34 and 35, and the sides of the gate 37 are covered with sloping portions 39, as are the other polysilicon gate 38 and the pad 36. Between the polysilicon pad 36 and the gate 37 there is a space, as there is between the gates 37 and 38, and there are no direct conductive paths there.

The next step (See Fig. 4) is to apply a coating or layer 40 of any refractory metal (e.g., Ti, Co, Ni, W, or Mo) or noble metal (e.g., Pt or Pd). Over this is applied a coating or layer 41 of amorphous silicon. The two layers 40 and 41 are sputter-deposited sequentially in one pump down to minimize the formation of interfaced oxide, which might retard silicide formation. The thickness of the amorphous silicon layer 41 is designed to react fully with the underlying layer 40 of refractory metal to form conductive silicide 46, 47, and 48 (See Fig. 5). There is also reaction with the polysilicon pads 36, 37, and 38.

Before these reactions a resist 42 is coated over the amorphous silicon layer 41, and portions of the layer 41 are etched away, preferably in a fluorine-based plasma ambient that has high selectivity to the underlying refractory metal layer 40, so then the MOSFETs are not exposed during etching. The result is to leave the conductive silicide layers 46, 47, and 48 as shown in Fig. 5.

Note that the refractory metal layer 40 and the amorphous silicon layer 41 extend over one sloping edge 39 of the pad 36 and over one sloping side 39 of the gate 38 and down into contact with the respective diffusion portions 31 and 32.

The conductive layers 46, 47, and 48 may be of TiW or TiN, that is titanium tungsten and titanium nitride, instead of silicide. The layers 46, 47, and 48 make a conductive structure, as a result of which there is contact between the pad 36 and the drain or source 31 and the gate or pad 38 and its adjacent drain or source 32.

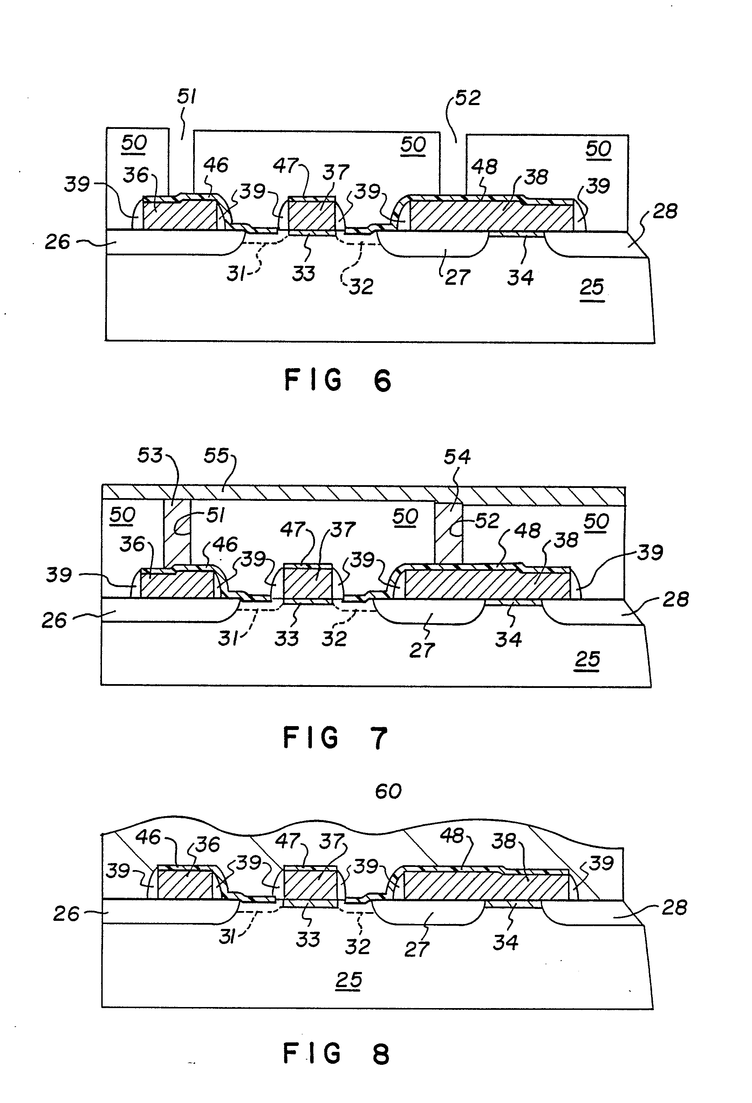

At this stage, the diffusion and gate contacts are made by applying a passivation layer 50 (Fig. 6), which is shaped to provide the desired contact openings 51 and 52. However, there is this very important difference from the prior art, -- the contact openings 51 and 52 terminate at exactly the same level; they are all coplanar. Thus, the contacts 46 and 48 down to the diffusion portions 34 and 35 are buried, but they still supply a conductive path between the diffusion layers 31 and 32 and the respective polysilicon pads 36 and 38. This means that there will be no problem with having to provide differential etching, which might result in different thicknesses for the silicide layers, and therefore tend to result in spiking and other problems.

The device is finished (Fig. 7) by adding metal plugs 53 and 54 in the openings 51 and 52 respectively and connecting metal 55 in contact with the plugs 53 and 54. Whether the openings 51 and 52 are made by an initial pattern or by etching later on does not make any difference, because the two openings 51 and 52 are the same depth, and the surfaces of the silicide 46 and 48 are on the same level. Hence, the plugs 53 and 54 are the same length or height. Without this important feature of the invention one would have different-height plugs for the diffusion contact plug and the polysilicon contact plug. The coplanar surfaces of the pads and gates 36 and 38 are therefore very important and result in identical heights of the plugs 53 and 54.

## An oversized contact scheme using the invention (Figs. 8-11)

Fig. 8 shows a structure substantially like that of Fig. 5. Over this structure is applied a first dielectric layer 60 to fill up the spaces in between the pads and gates.

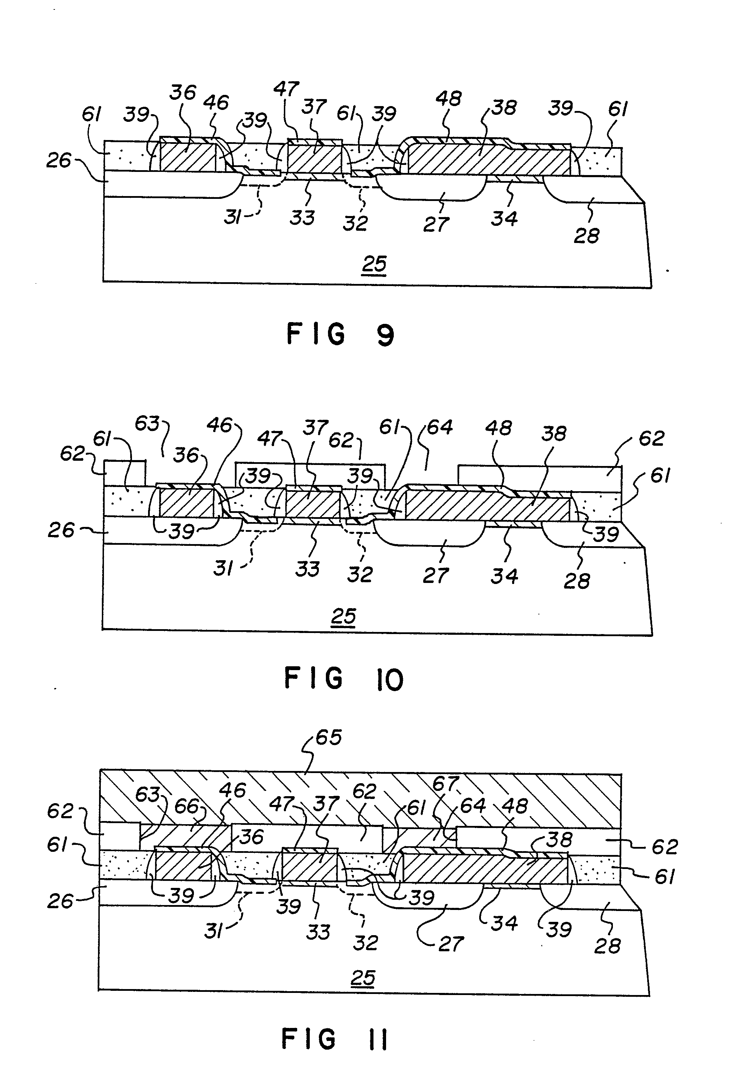

This first layer 60 is then etched to give the structure shown in Fig. 9, where the resultant layer 61 no longer extends over the silicide layers 46, 47 and 48. The material of the first dielectric 60 may be a low temperature oxide, such as phosphosilicate glass, borosilicate phosphate glass, TEOS, or a nitride.

Then, as shown in Fig. 10, a second dielectric layer 62 is applied over the whole wafer area. The diffusion and gate contact openings 63 and 64 are made by etching away parts of the layer 62. Here, the contact openings 63 may be wider than the pad 36 or the openings, 64, are misaligned to the pad 38 as shown in Fig. 10. The second layer 62 may be a polyimide, a plasma-enhanced nitride, or a spin-on glass, for example.

In the etching of the second dielectric 62 there is a differential effect: the polyimide, nitride or glass layer 62 etches at a rate at least ten times greater than the rate at which the same etchant acts on the first dielectric 61, so that the coating 46 and 48 is definitely exposed without affecting substantially the underneath layer 61 of the first dielectric.

In Fig. 11, metal 65 is added to complete the integrated circuit. When the metal 65 is added, oversized contacts 66 and external contact 67 are obtained over the pad 36 and over the gate 38. Here, again, the contact or plugs 66 and 67 are identical in height.

To those skilled in the art to which this invention relates, many changes in construction and widely differing embodiments and applications of the invention will suggest themselves without departing from the spirit and scope of the invention. The disclosures and the descriptions herein are purely illustrative and are not intended to be in any sense limiting.

## Claims

1. A method of forming an integrated circuit chip comprising the steps of:

(a) forming a substrate having a planar surface,

(b) forming on said substrate at least two field oxide regions separated from each other and having two separated diffusion regions, namely a source diffusion region and a drain diffusion region, all coplanar with said planar surface,

(c) forming at least three separate coplanar polysilicon deposits, comprising a gate deposit bridging over and between said two separated source and drain diffusion regions, and second and third deposits, each over one of said two field oxide regions,

(d) forming a highly conductive path over each said polysilicon deposit, the one over said gate being confined thereto, and the others extending from a top of a said polysilicon deposit down to and in good electrical contact with its adjacent diffusion region,

(e) forming a passivation layer over all of said integrated circuit portions so far described, covering all three of the polysilicon deposits, all of which are coplanar with each other,

(f) forming a hole in said passivation layer to each of said second and third coplanar polysilicon deposits, the holes being of identical depth, and

(g) providing metal plug contacts extending into each said hole that are identical in height.

2. The method of claim 1, wherein between steps (b) and (c) there is a step of providing a gate oxide layer that in step (c) is overlaid by some of said polysilicon deposits and is etched away between the gates.

3. The method of claim 1 wherein step (d) comprises coating with a refractive metal and the coating with amorphous silicon, followed by reaction between these two coatings to provide a conductive silicide and etching the silicide to limit the extent of said conductive path.

4. A method of forming an integrated circuit chip comprising the steps of:

(a) forming a substrate having a planar surface,

(b) forming on said substrate at least two field oxide regions. separated from each other and having two separated diffusion regions, namely a source diffusion region and a drain diffusion region, all coplanar with said planar surface,

(c) forming at least three separate coplanar polysilicon deposits, comprising a gate deposit bridging over and between said two separated source and drain diffusion regions, and second and third deposits, each over one of said two field oxide regions, with spaces between the polysilicon deposits.

(d) forming a highly conductive path over each said polysilicon deposit, the one over said gate being confined thereto, and the others extending from a top of a said polysilicon deposit down to and in good electrical contact with its adjacent diffusion region,

(e) forming a first dielectric layer covering those integrated circuit portions below the top level of the polysilicon deposits, all of which are coplanar with each other, and with the top level of the polysilicon deposits,

(f) forming a second dielectric layer over said first layer and over all portions of said integrated circuit above said first dielectric layer,

(g) removing portions of said second dielectric layer over the highly conductive paths that overlie said gate and said polysilicon deposits to provide wide gaps, larger than the same of said polysilicon deposits,

(h) providing metal contacts extending into the said gaps.

5. The method of claim 4, wherein between steps (b) and (c) there is a step of providing a a gate oxide layer that in step (c) is overlaid by some of said polysilicon deposits and is etched away between the gates.

6. The method of claim 4 wherein step (d) comprises coating with a refractive metal and the coating with amorphous silicon, followed by reaction between these two coatings to provide a conductive silicide and etching the silicide to limit the extent of said conductive path.

7. The method of claim 4 wherein said step (g) comprises etching with an etchant that acts at least ten times more rapidly on said second dielectric layer than on said first dielectric layer.

8. The method of claim 4 wherein said first dielectric layer is selected from the group consisting of phosphosilicate glass, borosilicate phosphate glass, TEOS, and nitrides, and second dielectric layer is selected from the groups consisting of polyimide, plasma enhanced nitride. and spin-on glass and said etchant is a plasma etchant.

9. An integrated circuit chip comprising:

a substrate having a planar surface,

at least two field oxide regions on said substrate separated from each other, each having a separate diffusion regions, one a source diffusion region and one a drain diffusion region, all coplanar with said planar surface,

at least three separate coplanar polysilicon deposits, comprising a gate deposit bridging over and between said two separated source and drain diffusion regions, and second and third deposits, each over one of said two field oxide regions,

a highly conductive path over each said polysilicon deposit, one over said gate and confined thereto, and two others extending from a top of a said polysilicon deposit down to and in good electrical contact with its adjacent diffusion region,

a passivation layer over all of said integrated circuit portions so far described, covering all three of the polysilicon deposits, all of which are coplanar with each other said passivation layer having an opening therethrough to each of said second and third coplanar polysilicon deposits, and

metal contacts of identical length extending into each said opening into contact with a said highly conductive path.

10. An integrated circuit chip comprising:

a substrate having a planar surface,

at least two field oxide regions on said substrate separated from each other and having two separated diffusion regions, namely a source diffusion region and a drain diffusion region, all coplanar with said planar surface,

at least three separate polysilicon deposits coplanar with each other, comprising a gate deposit bridging over and between said two separated source and drain diffusion regions, and second and third deposits, each over one of said two field oxide regions,

a highly conductive path over each said polysilicon deposit, the one over said gate being confined thereto, and the others extending from a top of a said polysilicon deposit down to and in good electrical contact with its adjacent diffusion region,

a first dielectric layer covering those integrated circuit portions below the top level of the polysilicon deposits, all of which are coplanar with each other, there being spaces between portions of said first dielectric layer,

a second dielectric layer over said first layer and over all portions of said integrated circuit above said first dielectric layer, with spaces providing openings therethrough over the highly conductive paths that overlie said gate and said polysilica deposits, and

metal contacts of identical length extending into said spaces.

PASSIVATION LAYER

FIG 1 (PRIOR ART)

METAL LAYER

FIG 2 (PRIOR ART)

EP 0 296 718 A2

EP 0 296 718 A2

FIG 3

FIG 4

FIG 5

FIG 6

FIG 7

FIG 8

**FIG 9**

**FIG 10**

**FIG 11**